# EUROPEAN PATENT APPLICATION

(11) **EP 4 600 665 A1**
(43) Date of publication of application: **13.08.2025**
(21) Application number: 25156631.1
(22) Date of filing: 07.02.2025
(51) Int. Cl.: G01R 19/175

(54) **ZERO CURRENT DETECTOR**

(30) Priority: 07.02.2024 FR 2401211
(71) Applicant: Dolphin Semiconductor, 38240 Meylan (FR)
(72) Inventor: NGUYEN, Van Ha, MONTREAL, QUEBEC, H3S 1N1 (CA); HUNG, Tang Tat, BROSSARD, QUEBEC, J4X 2R4 (CA); ROY, Charles, CHATEAUGUAY, QUEBEC, J6J 2Y6 (CA)
(74) Representative: Cabinet Beaumont

(57) **Abstract**

The present disclosure relates to a zero current detection (101) circuit comprising:
- a first comparator (101-Comp) configured to compare a first voltage (Vsw100), representative of a first current (IL101), with a first threshold voltage (Vos101);
- a calibration circuit (101-CAL) configured to modify the value of the first threshold voltage (Vos101) in view of process, voltage, and/or temperature variations.

## Description

### Technical field

The present disclosure relates generally to electronical circuits and devices. More particularly, the present disclosure concerns a zero current detection circuit.

### Background art

Zero current detection circuits are circuits that are capable of sensing a current in order to detect when said current is equal to zero. They are commonly used in voltage converter circuits, such as DC-DC converters.

It would be desirable to at least partly improve certain aspects of known zero current detection circuits.

### Summary of Invention

There is a need for a zero current detection circuit having relatively high precision.

One embodiment addresses all or some of the drawbacks of known zero current detection circuits.

One embodiment provides a zero current detection circuit comprising:
- a first comparator configured to compare a first voltage, representative of a first current, with a first threshold voltage;
- a calibration circuit configured to modify the value of the first threshold voltage in view of process, voltage, and/or temperature variations.

According to an embodiment, said first threshold voltage is an offset voltage of said first comparator.

According to an embodiment, wherein said calibration circuit comprises a second comparator circuit.

According to an embodiment, said second comparator circuit is more precise than the first comparator.

According to an embodiment, the circuit comprises a logic circuit configured to be the main control circuit of the zero current detection circuit.

Another embodiment provides a DC-DC converter comprising a zero current detection circuit described previously.

According to an embodiment, the converter comprises two switches coupled in series, and a coil having one of its terminals coupled to the middle node between said two switches.

According to an embodiment said zero current detection circuit is configured to detect when the current in said coil is equal to zero.

### Brief description of drawings

The foregoing features and advantages, as well as others, will be described in detail in the following description of specific embodiments given by way of illustration and not limitation with reference to the accompanying drawings, in which:
Figure 1 illustrates an example application of an embodiment of a zero current detection circuit;
Figure 2 is a timing diagram showing an example of execution of a zero current detection circuit;
Figure 3 is a block diagram illustrating a zero current detector according to an embodiment;
Figure 4 illustrates, in more detail, a circuit of the embodiment of Figure 3;
Figure 5 illustrates, in more detail, another circuit of the embodiment of Figure 3;
Figure 6 illustrates, in more detail, another circuit of the embodiment of Figure 3;
Figure 7 illustrates, in more detail and partially in block form, another circuit of the embodiment of Figure 3;
Figure 8 illustrates, in more detail, a part of the circuit of Figure 7;
Figure 9 illustrates, in more detail, a part of the circuit of Figure 7;
Figure 10 illustrates, in more detail, a part of the circuit of Figure 7;
Figure 11 illustrates, in more detail, a part of the circuit of Figure 7; and
Figure 12 illustrates, in more detail, another circuit of the embodiment of Figure 3.

### Description of embodiments

Like features have been designated by like references in the various figures. In particular, the structural and/or functional features that are common among the various embodiments may have the same references and may dispose identical structural, dimensional and material properties.

For the sake of clarity, only the operations and elements that are useful for an understanding of the embodiments described herein have been illustrated and described in detail.

Unless indicated otherwise, when reference is made to two elements connected together, this signifies a direct connection without any intermediate elements other than conductors, and when reference is made to two elements coupled together, this signifies that these two elements can be connected or they can be coupled via one or more other elements.

In the following disclosure, unless indicated otherwise, when reference is made to absolute positional qualifiers, such as the terms "front", "back", "top", "bottom", "left", "right", etc., or to relative positional qualifiers, such as the terms "above", "below", "higher", "lower", etc., or to qualifiers of orientation, such as "horizontal", "vertical", etc., reference is made to the orientation shown in the figures.

Unless specified otherwise, the expressions "around", "approximately", "substantially" and "in the order of" signify within 10 %, and preferably within 5 %.

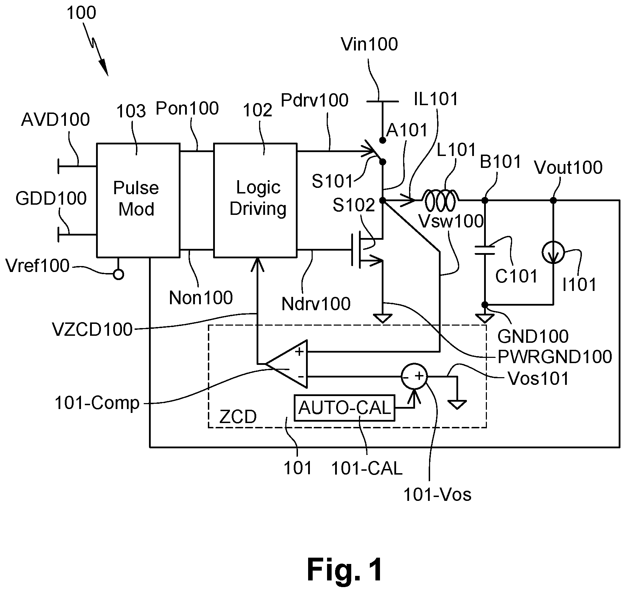

Figure 1 represents, very schematically and partially in block form, a DC-DC converter circuit 100 comprising an embodiment of a zero current detection (ZCD) circuit 101.

DC-DC converter circuit 100 comprises two switches S101 and S102 connected in series between a first node receiving an input voltage Vin100 and a second node receiving a first reference voltage PWRGND100, for example the ground.

According to an example, switches S101 and S102 are both metal-oxide-semiconductor field-effect transistors, also known as MOSFET transistors or MOS transistors. More particularly, switch S101 is a P-type MOS transistor, also known as a P-channel MOS transistor, or PMOS transistor, and switch S102 is a N-type transistor, also known as an N-channel MOS transistor, or NMOS transistor. The source terminal of switch S101 is coupled, preferably connected, to the first node receiving the input voltage Vin100, and the drain terminal of switch S101 is coupled, preferably connected, to the drain terminal of switch S102. The source terminal of switch S102 is coupled, preferably connected, to the second node receiving the reference voltage PWRGND100. Gate terminals of switches receive control voltages from a driving circuit 102 (Logic Driving). More particularly, switch S101 receives a control voltage Pdrv100 from the driving circuit 102 at its gate terminal, and switch S102 receives a control voltage Ndrv100 from the driving circuit 102 at its gate terminal.

According to another example, switches S101 and S102 are both NMOS transistors.

According to another example, switches S101 and S102 can be implemented by another type of transistor, such as by bipolar transistors.

Driving circuit 102 is a circuit capable of providing the control voltages Pdrv100 and Ndrv100 after receiving two pulse signals Pon100 and Non100 from a pulse modulator circuit 103 (Pulse Mod) and a control voltage VZCD100 from the embodiment of the zero current detection circuit 101. According to an example, signals Pon100 and Non100 are nonoverlapping signals. The person skilled in the art will understand how such a circuit can be implemented. According to an example, pulse modulator circuit 103 is supplied by a supply voltage AVD100 and a second reference voltage GND100 different from the first reference voltage PWRGND100.

Pulse modulator circuit 103 is a circuit capable of providing the two pulse signals Pon100 and Non100 based on a reference voltage Vref100. Reference voltage Vref100 is different from the reference voltage GND100. The person skilled in the art will understand how such a circuit can be implemented.

DC-DC converter circuit 100 further comprises a coil L101 coupled between the middle node between switches S101 and S102, referenced A101, and corresponding to the drain terminals of switches S101 and S102, and an output node B101. The zero current detection circuit 101 is configured to monitor the input current IL101 of coil L101. The voltage between node A101 and the reference voltage GND100 is labelled Vsw100. The output voltage Vout100 of DC-DC converter 100 is provided between node B101 and the node receiving the reference voltage GND100.

DC-DC converter circuit 100 further comprises a capacitor C101 coupled between node B101 and the node receiving second reference voltage GND100.

DC-DC converter circuit 100 further comprises a current source I101 coupled between node B101 and the node receiving second reference voltage GND100.

According to an embodiment, zero current detection circuit 101 comprises a comparator 101-Comp capable of comparing voltage Vsw100 to a threshold voltage Vos101. Voltage Vsw100 is representative of the input current IL101 of coil L101. Threshold voltage Vos101 is used for compensating an internal offset and delay of comparator 101-Comp, for example, due to process, voltage and temperature (PVT) variations.

Zero current detection circuit 101, also referred to herein as zero current detector 101, further comprises a voltage source 101-Vos providing the threshold voltage Vos101, and an autocalibration circuit 101-CAL. According to an embodiment, autocalibration circuit 101-CAL is used to configure the voltage source 101-Vos in order to take into account environmental variations, such as temperature variations, and/or manufacturing variations such as process variations, and/or voltage variations. In other words, the autocalibration circuit 101-CAL is used to take into account what are often referred to as PVT variations of comparator 101-Comp, where PVT stands for Process Voltage and Temperature.

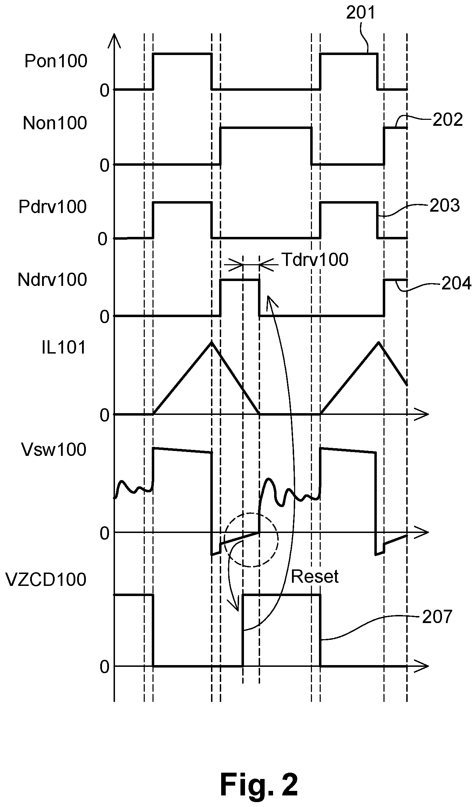

Operation of the zero current detection circuit 101 is described in more detail in relation with Figure 2.

Voltage Vsw100 is generated by the DC-DC converter's switching actions via the power switches S101 and S102. More particularly, the DC-DC fundamental operation is the following.

When switch S101 is ON, switch S102 is OFF (controlled via Pdrv and Ndrv voltages), node providing voltage Vsw100 receives voltage Vin100 via switch S101, output voltage Vout100, capacitor C101 and the inductor L101 are charged (so inductor current IL101 ramps up).

When switch S101 is OFF, switch S102 is ON (controlled via Pdrv and Ndrv signals), node providing voltage Vsw100 receives voltage PWRGND100 via switch S102, output voltage Vout100, capacitor C101, and the inductor L101 are discharged (so inductor current IL101 ramps down).

The zero current detector operation is the following.

Voltage Vsw100 is used to detect the condition of the inductor current during ramping down of the inductor L101 in the phase where switch S101 is OFF and switch S102 is ON. In particular:
- If switch S102 is OFF before inductor current reaches zero ampere, inductor current will triggered the body diode of switch S102, and thus voltage Vsw100 is equal to a voltage - VD corresponding to the opposite of a voltage VD of the body diode of switch S102, this means that the main comparator of the ZCD detects zero current condition too early, and
- If switch S102 is OFF after inductor current reaches zero ampere, inductor current will continue going through switch S102, and thus voltage Vsw100 is equal to a voltage equal to the product of the inductor current value and the on-resistance of the N-type power switch S102, this means that the main comparator of the ZCD detects zero current condition too late.

The too early or too late detections are then corrected by the ZCD-turn, which is described in details hereafter. This ZCD-turn block also has a comparator which compares voltage Vsw100 versus voltage PWRGND100 and adjusting a correction voltage described hereafter. This correction voltage Vcorr300 then change the offset voltage of the main comparator via the currents described hereafter.

Figure 2 is a timing diagram illustrating an example of operation of the DC-DC converter circuit 100 described in relation with Figure 1, and more particularly illustrating operation of the zero current detection circuit 101.

Figure 2 comprises:
- a trace 201 illustrating the timing evolution of pulse voltage Pon100;
- a trace 202 illustrating the timing evolution of pulse voltage Non100;
- a trace 203 illustrating the timing evolution of control voltage Pdrv100;
- a trace 204 illustrating the timing evolution of control voltage Ndrv100;
- a trace 205 illustrating the timing evolution of input current IL101 of coil L101;
- a trace 206 illustrating the timing evolution of voltage Vsw100; and
- a trace 207 illustrating the timing evolution of control voltage VZCD100.

Each rising edge of pulse voltage Pon100 triggers a rising edge of the control voltage Pdrv100. This causes the input voltage Vin100 to be transferred to coil L101. Thus, current IL101 increases. Similarly, each falling edge of pulse voltage Pon100 triggers a falling edge of the control voltage Pdrv100, which stops the rising of current IL101.

Each rising edge of pulse voltage Non100 causes a rising edge of the control voltage Ndrv100. This causes the reference voltage GND100 to be transferred to coil L101. Thus, current IL101 decreases.

However, a falling edge of pulse signal Non100 does not cause a falling edge of control voltage Ndrv100. A falling edge of pulse signal Non100 is controlled by the driving circuit 102 based on an internal delay configured by circuit 102 and based on the control voltage VZCD100 provided by zero current detection circuit 101. More particularly, a falling edge of control voltage Ndrv100 should occur when current IL101 reaches zero Amps.

Threshold voltage Vos101 is supposed to be dimensioned to compensate for an internal offset voltage of comparator 101-Comp, and to take into account a delay Tdrv100 of driving circuit 102. Delay Tdrv100 corresponds to the duration between a time when the driving circuit detects a rising edge of control voltage VZCD100 and a time when the driving circuit causes a falling edge of the control voltage Ndrv100. However, due to PVT variations, threshold voltage Vos101 should generally be adjusted in real time, to ensure a high precision of the DC-DC converter circuit 100.

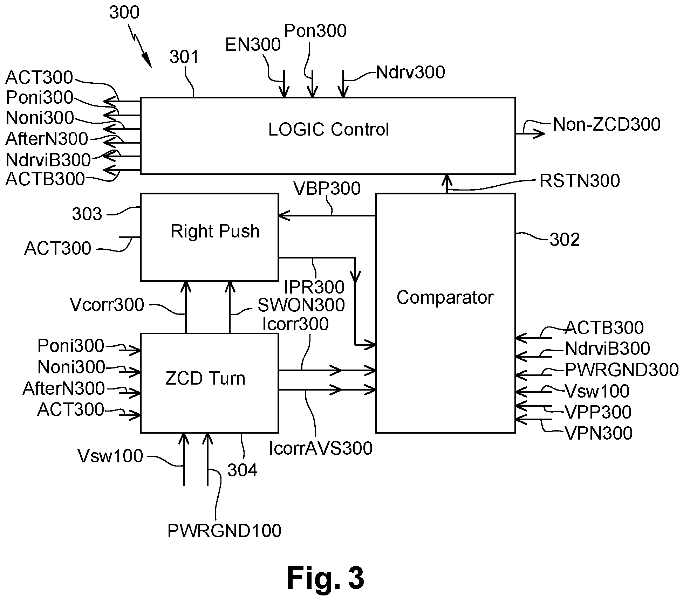

Figure 3 is a block diagram illustrating an embodiment of a zero current detection circuit 300 of a similar type to the zero current detection circuit 100 described in relation with Figure 1.

Zero current detection circuit 300, also referred to herein as zero current detector 300 or ZCD circuit 300, comprises:
- a logic circuit 301 (LOGIC Control);
- a comparator 302 (Comparator);
- a circuit 303 (Right Push); and
- a circuit 304 (ZCD Turn).

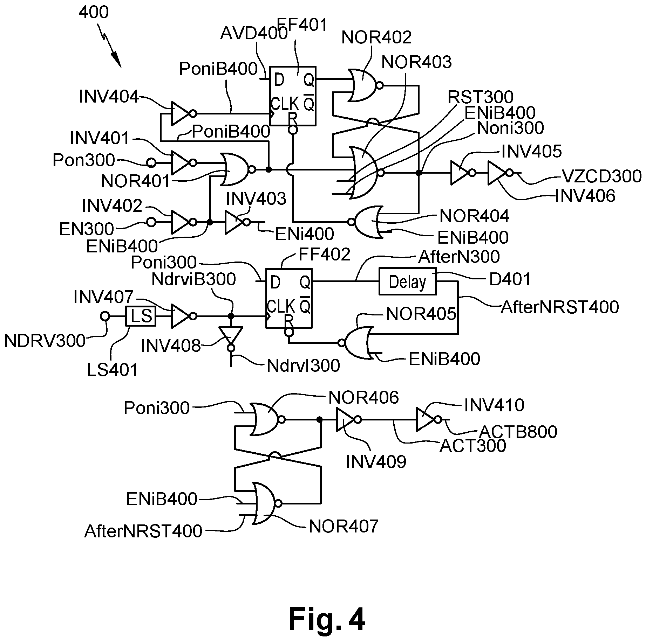

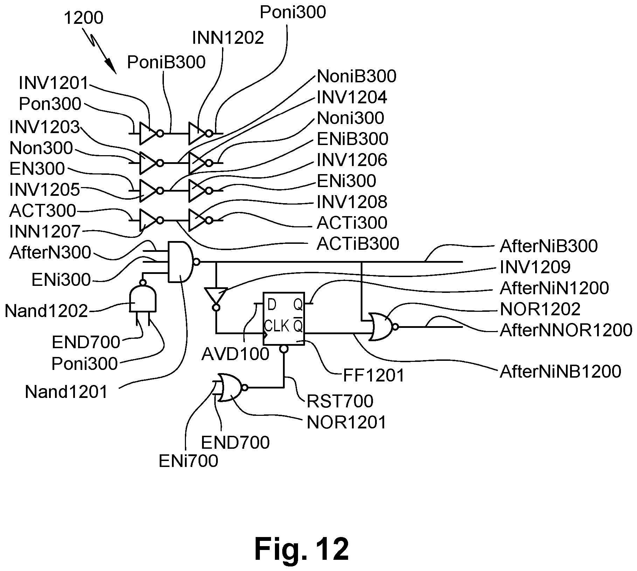

Logic circuit 301 is the main control circuit of ZCD circuit 300. Logic circuit 301 provides an external control voltage Non-ZCD300 similar to the control voltage VZCD100 described in relation with Figure 1. According to an example, logic circuit 301 further provides internal voltages and currents, such as voltages ACT300, ACTB300, Poni300, Noni300, AfterN300, and NdrviB300, which are described in more detail in relation with Figures 4 to 12. An example of logic circuit 301 is described in more details in relation with Figure 12.

According to an example, logic circuit 301 receives an internal reset voltage RSTN300, described in more detail in relation with Figures 4 to 12, and external voltages such as:
- an enabling voltage EN300 described in more detail in relation with Figures 4 to 12;
- a voltage Pon300 of similar type to the voltage Pon100 described in relation with Figure 1, and described in more detail in relation with Figures 4 to 12; and
- a voltage Ndrv300 of similar type to the voltage Ndrv100 described in relation with Figure 1, and described in more detail in relation with Figures 4 to 12.

Comparator 302 is the main comparator of zero current detection circuit 300. Comparator 302 is of a similar type to the comparator 101-Comp described in relation with Figure 1. According to an example, comparator 302 receives the following voltages and currents: voltages ACTB300, Ndrvi300, PWRGND100, Vsw100, VPP300 and VPN300, which are described in more detail in relation with Figures 4 to 12, and currents Icorr300 and IcorrAVS300, which are described in more detail in relation with Figures 4 to 12.

According to an example, comparator 302 is configured to generate the reset voltage RSTN300, and a voltage VBP300 described in more detail in relation with Figures 4 to 12. According to an example, voltage VBP300 is a biasing voltage.

The combination of the circuits 303 and 304 forms an autocalibration circuit of a similar type to the autocalibration circuit 101-CAL described in relation with Figure 1.

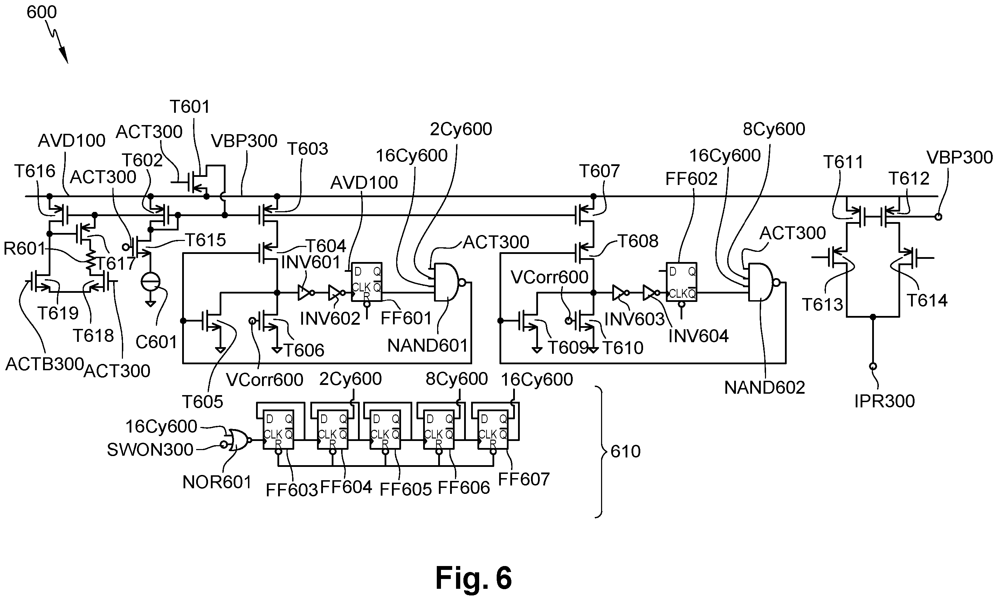

Circuit 303 is a circuit capable of detecting when the internal offset voltage of comparator 302 causes a false detection of the monitored current. More particularly, circuit 303 is capable of generating a push signal whenever the comparator detects that the monitored current is positive because of the value of the offset voltage. Operation of the circuit 303 is described in relation with Figure 6.

According to an example, circuit 303 receives a voltage VBP300, a correction voltage Vcorr300 and a voltage SWON300, which are described in more detail in relation with Figures 4 to 12.

According to an example, circuit 303 is configured to generate a voltage ACT300 and a current IPR300. According to an example, current IPR300 is provided to the comparator 302.

As stated earlier, circuit 304 is part of the autocalibration circuit, and is used to correct the offset voltage of comparator 302. Circuit 304 for example receives the voltage Poni300, the voltage Noni300, the voltage AfterN300, the voltage ACT300, the voltage Vsw100, and the reference voltage PWRGND100.

Circuit 304 is for example configured to generate the following voltages and currents:
- correction voltage Vcorr300;
- voltage SWON300;
- current Icorr300; and
- current IcorrAVS300.

Figure 4 represents, in more detail, an example of a logic circuit 400 for implementing the logic circuit 301 of zero current detection circuit 300 described in relation with Figure 3.

As described previously, logic circuit 400 receives voltages Pon300, EN300 and Ndrv300.

Logic circuit 400 for example comprises three inverters INV401, INV402 and INV403, and a NOR gate NOR401. Inverter INV401 receives the voltage Pon300, and inverter INV402 receives the voltage EN300. A first input of NOR gate NOR401 is coupled, preferably connected, to the output of inverter INV401, and a second input of NOR gate NOR401 is coupled, preferably connected, to the output of inverter INV402 providing a voltage ENiB400. An input of inverter INV403 is coupled, preferably connected, to the output of inverter INV402.

Logic circuit 400 further comprises a flip flop FF401, one inverter INV404, and three NOR gates NOR402, NOR403 and NOR404.

Flip flop FF401 is a D type flip flop, comprising three inputs R, CLK and D, and two outputs Q and Q. Input D of flip flop FF401 receives a supply voltage AVD100, and input CLK of flip flop FF401 is coupled, preferably connected, to an output of inverter INV404 and receives a voltage PoniB400. An input of inverter INV404 is coupled, preferably connected, to an output of NOR gate NOR401 providing voltage Poni300.

A first input of NOR gate NOR402 is coupled, preferably connected, to the output Q of flip flop FF401, a second input of NOR gate NOR402 is coupled, preferably connected, to an output of NOR gate NOR403. An output of NOR gate NOR402 is coupled, preferably connected, to a first input of NOR gate NOR403.

A second input of NOR gate NOR403 is coupled, preferably connected, to the output of NOR gate NOR401. A third input of NOR gate NOR403 receives reset voltage RST300, and a fourth input of NOR gate NOR403 receives voltage ENiB300.

A first input of NOR gate NOR404 provides voltage Noni300, and is coupled, preferably connected, to the output of NOR gate NOR403, and a second input of NOR gate NOR404 receives voltage ENiB400. An output of NOR gate NOR404 is coupled, preferably connected, to the reset input R of flip flop FF401.

Logic circuit 400 further comprises two inverters INV405 and INV406. An input of inverter INV405 is coupled, preferably connected, to the output of NOR gate NOR403, and an output of inverter INV405 is coupled, preferably connected, to an input of inverter INV406. An output of inverter INV406 provides voltage NON-ZCD300.

Logic circuit 400 further comprises a second flip flop FF402, two inverters INV407 and INV408, a level shifter LS401 (LS), another NOR gate NOR405, and a delay element D401.

Flip flop FF402 is a D type flip flop, comprising three inputs R, CLK and D, and two outputs Q and Q. The input D of flip flop FF402 receives the voltage Poni300. The input CLK of flip flop FF402 receives the voltage NdrviB300, and is coupled, preferably connected, to an output of the inverter INV407 and to an input of inverter INV408. An input of inverter INV407 is coupled, preferably connected, to an output of level shifter LS401, and an output of the inverter INV408 provides a voltage Ndrvi300. According to an example, an input of level shifter LS401 receives the voltage Ndrv300. Output Q of flip flop FF402 provides the voltage AfterN300, and is coupled, preferably connected, to an input of delay element D401.

An output of the delay element D401 provides voltage AfterNRST400, and is coupled, preferably connected, to a first input of NOR gate NOR405. A second input of NOR gate NOR405 receives voltage ENiB400. An output of NOR gate NOR405 is coupled, preferably connected, to the reset input R of flip flop FF402.

Logic circuit 400 further comprises two NOR gates NOR406 and NOR407, and two inverters INV409 and INV410. A first input of NOR gate NOR406 receives the voltage Poni300, and a second input of NOR gate NOR406 is coupled, preferably connected, to an output of the NOR gate NOR407. An output of NOR gate NOR406 is coupled, preferably connected, to an input of inverter INV409 and to a first input of NOR gate NOR407. An output of the inverter INV409 provides the voltage ACT300, and is coupled, preferably connected, to an input of inverter INV410, and an output of inverter INV410 provides voltage ACTB300.

A second input of NOR gate NOR407 receives the voltage ENiB400. A third input of NOR gate NOR407 receives the voltage AfterNRST400.

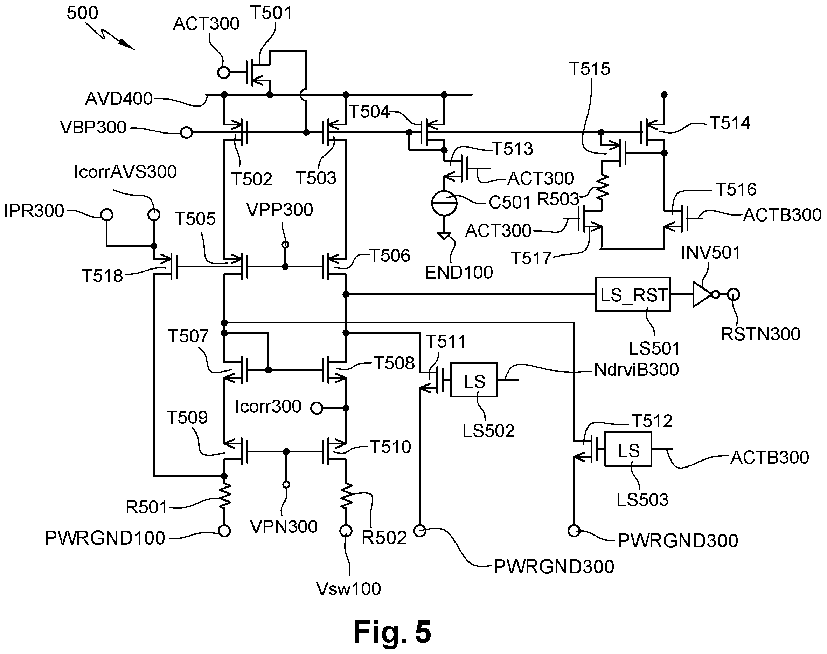

Figure 5 represents, in more detail, an example of a comparator 500 for implementing the main comparator 101-COMP of zero current detection circuit 101 described in relation with Figure 1, or the main comparator 302 of zero current detection circuit 300 described in relation with Figure 3.

As described previously, comparator 500 receives the voltages ACTB300, NdrviB300, PWRGND100, Vsw100, VPP300, VPN300 and the currents Icorr300, IcorrAVS300, and IPR300.

Comparator 500 comprises, for example, a PMOS transistor T501 receiving at its gate terminal the voltage ACT300. A source terminal of transistor T501 is coupled, preferably connected, to a node providing the supply voltage AVD100. A drain terminal of transistor T501 is coupled, preferably connected, to a gate terminal of a first differential pair. Transistor T501 is for example controlled by a circuit similar to the circuit 301 described in relation with Figure 3, or circuit 400 described in relation with Figure 4. Transistor T501 is used to turn OFF comparator 400 when needed.

The first differential pair comprises two PMOS transistors T502 and T503. A source terminal of transistor T502 and a source terminal of transistor T503 are coupled, preferably connected, to each other, and to the source terminal of transistor T501 and to the node providing the supply voltage AVD100. A gate terminal of transistor T502 and a gate terminal of transistor T503 are coupled, preferably connected, to each other, and to the drain terminal of transistor T501.

Comparator 500 further comprises a PMOS transistor T504, a NMOS transistor T513, and a current source C501. A source terminal of transistor T504 is coupled, preferably connected, to the node providing the supply voltage AVD100. A drain terminal of transistor T504 receives the biasing voltage VBP300. A gate terminal of transistor T504 is coupled, preferably connected, to the gate terminals of transistors T502 and T503, and receives biasing voltages VBP300. A source terminal of transistor T513 receives a current generated by the current source C501. A drain terminal of transistor T513 is coupled, preferably connected, the drain terminal of transistor T504. A gate terminal of transistor T513 receives the voltage ACT300. The current source C501 receives the reference voltage GND100. Transistors T504 and T513 and the current source C501 are used for biasing.

Comparator 500 further comprises two PMOS transistors T514 and T515, two NMOS transistors T516 and T517, and a resistor R503. A source terminal of transistor T514 is coupled, preferably connected, to the node providing the supply voltage AVD100. A drain terminal of transistor T514 is coupled, preferably connected, to the gate terminal of transistor T515 and to the drain terminal of transistor T516. A gate terminal of transistor T514 receives the biasing voltage VBP300. A source terminal of transistor T515 receives the biasing voltage VBP300. A drain terminal of transistor T514 is coupled, preferably connected, to a first terminal of resistor R503. A source terminal of transistor T516 is coupled, preferably connected, to a source terminal of transistor T517. A gate terminal of transistor T516 receives the voltage ACTB300. A gate terminal of transistor T517 receives the voltage ACT300. These transistors T514 to T517 are used to pull the biasing voltage VBP300 down fast when the voltage ACT300 is equal to a high level.

Comparator 500 further comprises, for example, a second differential pair comprising two PMOS transistors T505 and T506. A source terminal of transistor T505 is coupled, preferably connected, to the drain terminal of transistor T502. A source terminal of transistor T506 is coupled, preferably connected, to the drain terminal of transistor T503. Gate terminals of transistors T505 and T506 are coupled, preferably connected, to each other, and to a node receiving the voltage VPP300.

Comparator 500 further comprises, for example, a level shifter LS501 (LS-RST) and an inverter INV501. An input of the level shifter LS501 is coupled, preferably connected, to the drain terminal of transistor T506. An output of level shifter LS501 is coupled, preferably connected, to an input of inverter INV501. An output of inverter INV501 provides the reset voltage RSTN300.

Comparator 500 further comprises, for example, a current mirror comprising two NMOS transistors T507 and T508. A drain terminal of transistor T507 is coupled, preferably connected, to the drain terminal of transistor T505 and to the gate terminals of transistor T507 and T508. A drain terminal of transistor T508 is coupled, preferably connected, to the drain terminal of transistor T506.

Comparator 500 further comprises, for example, a third differential pair comprising two NMOS transistors T509 and T510. A source terminal of transistor T509 is coupled, preferably connected, to the source terminal of transistor T507. A source terminal of transistor T510 is coupled, preferably connected, to the source terminal of transistor T508. A gate terminal of transistor T509 and a gate terminal of transistor T510 are coupled, preferably connected, to each other, and to a node receiving voltage VPN300.

According to an example, current Icorr300 can be supplied to comparator 500 at source terminals of transistors T508 and T510.

Comparator 500 further comprises, for example, a PMOS transistor T518. A source terminal of transistor T518 receives current IcorrAVS300, and current IRP300. A drain terminal of transistor T518 is coupled, preferably connected, to the drain terminal of transistor T509. A gate terminal of transistor T518 is coupled, preferably connected, to the node receiving voltage VPP300.

Comparator 500 further comprises two resistors R501 and R502. A first terminal of resistor R501 is coupled, preferably connected, to a drain terminal of transistor T509, and a second terminal of resistor R501 is coupled, preferably connected, to a node receiving reference voltage PWRGND100. A first terminal of resistor R502 is coupled, preferably connected, to a drain terminal of transistor T510, and a second terminal of resistor R502 is coupled, preferably connected, to a node receiving the voltage Vsw100.

Transistors T502, T503, T507 and T508 and resistors R501 and R502 for example form the comparator 500. Transistors T505, T506, T509 and T510 are for example protection devices.

Comparator 500 further comprises, for example, a level shifter LS502 (LS) and an NMOS transistor T511. An input of the level shifter LS502 receives the voltage NdrviB300. An output of level shifter LS502 is coupled, preferably connected, to a gate terminal of transistor T511. A drain terminal of transistor T511 is coupled, preferably connected, to the drain terminals of transistors T506 and T508. A source terminal of transistor T511 receives reference voltage PWRGND100.

Comparator 500 further comprises, for example, a level shifter LS503 (LS) and an NMOS transistor T512. An input of the level shifter LS503 receives the voltage ACTB300. An output of level shifter LS503 is coupled, preferably connected, to a gate terminal of transistor T512. A drain terminal of transistor T512 is coupled, preferably connected, to the drain terminals of transistors T505 and T507. A source terminal of the transistor T512 receives reference voltage PWRGND100.

According to an example, comparator 500 does not use the same ground domain as the other circuits of the zero current detection circuit. In such a case, the level shifters LS501, LS502, and LS503 are for example used to switch ground domains within comparator 500.

Figure 6 represents, in more detail, an example of a circuit 600 for implementing the circuit 303 of the zero current detection circuit 300 described in relation with Figure 3.

As described previously, the circuit 600 receives the voltages VACT300, VBP300, SWON300, and Vcorr300, and the current IPR300.

Circuit 600 for example comprises a PMOS transistor T601 receiving at its gate terminal the voltage ACT300. A source terminal of a transistor T601 is coupled, preferably connected, to a node providing the supply voltage AVD100. A drain terminal of transistor T601 is coupled, preferably connected, to a gate terminal of a first differential pair. Transistor T601 is controlled by a circuit of a similar type to the circuit 301 described in relation with Figure 3, or the circuit 400 described in relation with Figure 4. Transistor T601 is used to turn OFF circuit 600 when needed.

The first differential pair for example comprises two PMOS transistors T602 and T603. A source terminal of transistor T602 and a source terminal of transistor T603 are coupled, preferably connected, to each other, and to the source terminal of transistor T601 and to the node providing the supply voltage AVD100. A gate terminal of transistor T602 and a gate terminal of transistor T603 are coupled, preferably connected, to each other, and to the drain terminal of the transistor T601.

Circuit 600 further comprises, for example, a current source C601 and a NMOS transistor T615. A source terminal of transistor T615 receives a current from the current source C601. A drain terminal of transistor T615 is coupled, preferably connected, to the drain terminal of transistor T602. The gate terminal of transistor T615 receives the voltage ACT300.

Circuit 600 further comprises two PMOS transistors T616 and T617, two NMOS transistors T618 and T619, and a resistor R601. A source terminal of transistor T616 is coupled, preferably connected, to the node providing the supply voltage AVD100. A drain terminal of transistor T616 is coupled, preferably connected, to the gate terminal of transistor T617 and to the drain terminal of transistor T619. A gate terminal of transistor T616 receives the biasing voltage VBP300. A source terminal of transistor T617 receives the biasing voltage VBP300. A drain terminal of transistor T617 is coupled, preferably connected, to a first terminal of resistor R601. A second terminal of resistor R601 is coupled, preferably connected, to a drain terminal of transistor T618. A source terminal of transistor T618 is coupled, preferably connected, to a source terminal of transistor T619. A gate terminal of transistor T619 receives the voltage ACTB300. A gate terminal of transistor T618 receives the voltage ACT300. These transistors T616 to T619 are used to pull the biasing voltage VBP300 down fast when the voltage AZCT300 is equal to a high level.

Circuit 600 further comprises, for example, three transistors T604, T605, and T606. A source terminal of transistor T604 is coupled, preferably connected, to a drain terminal of transistor T603. A drain terminal of transistor T604 is coupled, preferably connected, to drain terminals of transistors T605 and T606. Gate terminals of transistors T604 and T605 are coupled, preferably connected, to each other. A gate terminal of transistor T606 is coupled, preferably connected, to a node receiving a correction voltage VCorr600. Source terminals of transistors T605 and T606 are for example referenced to the ground.

Circuit 600 further comprises, for example, two inverters INV601 and INV602, a flip flop FF601 and a NAND gate NAND601. Flip flop FF601 is for example a D type flip flop, comprising three inputs R, CLK and D, and two outputs Q and ***Q̅*.**

An input of inverter INV601 is coupled, preferably connected, to the drain terminals of transistors T604, T605 and T606. An output of inverter INV601 is coupled, preferably connected, to an input of inverter INV602. An output of inverter INV602 is coupled, preferably connected, to the CLK input of flip flop FF601. The D input of flip flop FF601 for example receives supply voltage AVD100. The ***Q̅*** output of flip flop FF601 is coupled, preferably connected, to a first input of NAND gate NAND601. A second input of NAND gate NAND601 receives a voltage 16Cy600. A third input of NAND gate NAND601 receives a voltage 2Cy600. A fourth input of NAND gate NAND601 receives a voltage ACT300. An output of NAND gate NAND601 is coupled, preferably connected, to the gate terminals of transistors T604 and T605.

Circuit 600 for example further comprises four transistors T607, T608, T609, and T610. A source terminal of transistor T607 is coupled, preferably connected, to the node providing supply voltage AVD100. A drain terminal of transistor T607 is coupled, preferably connected, to a source terminal of transistor T608. A gate terminal of transistor T607 is coupled, preferably connected, to the gate terminals of transistors T602 and T603.

A drain terminal of transistor T608 is coupled, preferably connected, to drain terminals of transistors T609 and T610. Gate terminals of transistors T608 and T609 are coupled, preferably connected, to each other. A gate terminal of transistor T610 is coupled, preferably connected, to a node receiving the correction voltage VCorr600. Source terminals of transistors T609 and T610 are referenced to the ground.

Circuit 600 for example further comprises two inverters INV603 and INV604, a flip flop FF602 and a NAND gate NAND602. Flip flop FF602 is a D type flip flop, comprising three inputs R, CLK and D, and two outputs Q and Q.

An input of inverter INV603 is coupled, preferably connected, to the drain terminals of transistors T608, T609 and T610. An output of inverter INV603 is coupled, preferably connected, to an input of inverter INV604. An output of inverter INV604 is coupled, preferably connected, to the CLK input of flip flop FF602. The D input of flip flop FF602 receives supply voltage AVD100. The Q output of flip flop FF602 is coupled, preferably connected, to a first input of NAND gate NAND602. A second input of NAND gate NAND602 receives voltage 16Cy600. A third input of NAND gate NAND602 receives a voltage 8Cy600. A fourth input of NAND gate NAND602 receives a voltage ACT300. An output of NAND gate NAND602 is coupled, preferably connected, to the gate terminals of transistors T608 and T609.

Circuit 600 further comprises, for example, a second differential pair comprising two PMOS transistors T611 and T612. Source terminals of transistors T611 and T612 are coupled, preferably connected, to the node providing supply voltage AVD100. Gate terminals of transistors T611 and T612 are coupled, preferably connected, to each other and to a node receiving voltage VBP300.

Circuit 600 further comprises, for example, two PMOS transistors T613 and T614. A source terminal of transistor T613 is coupled, preferably connected, to the drain terminal of transistor T611. A source terminal of transistor T614 is coupled, preferably connected, to the drain terminal of transistor T612. Drain terminals of transistors T613 and T614 receive current IPR300.

Circuit 600 further comprises, for example, a circuit 610 providing voltages 2Cy600, 8Cy600 and 16Cy600.

Circuit 610 comprises, for example, a NOR gate NOR601 receiving, at a first input, the voltage 16Cy600, and, at a second input, the voltage SWON300.

Circuit 610 further comprises, for example, five flip flops FF603, FF6064, FF605, FF606 and FF607. Flip flops FF603 to FF607 are D type flip flops, each comprising three inputs R, CLK and D, and two outputs Q and Q. The output of NOR gate NOR601 is coupled, preferably connected, to the CLK terminal of flip flop FF603. The output Q of flip flop FF603 is coupled, preferably connected, to the input D of flip flop FF603 and to the CLK terminal of flip flop FF604. The output ***Q̅*** of flip flop FF604 is coupled, preferably connected, to the input D of flip flop FF604 and to the CLK terminal of flip flop FF605. The output Q of flip flop FF604 provides the voltage 2Cy600. The output ***Q̅*** of flip flop FF605 is coupled, preferably connected, to the input D of flip flop FF605 and to the CLK terminal of flip flop FF606. The output ***Q̅*** of flip flop FF606 is coupled, preferably connected, to the input D of flip flop FF606 and to the CLK terminal of flip flop FF607. The output Q of flip flop FF606 provides voltage 8Cy600. The output Q of flip flop FF607 provides voltage 16Cy600.

Circuit 600 is used to verify the detection of the inductor current, and guarantees the inductor current to be negative, meaning lower than zero, to allow the zero current detection circuit to work properly. There are two phases of operation. During the first phase, after two first cycles of SWON signal, if inductor current is positive, transistor T613 is rendered conductive to provide more offset current to the main current comparator by injecting more current to the main current comparator. During the second phase, after eight first cycles of SWON signal, if the inductor current is still positive, T614 is rendered conductive to provide more offset current to the main current comparator by injecting more current to the main current comparator.

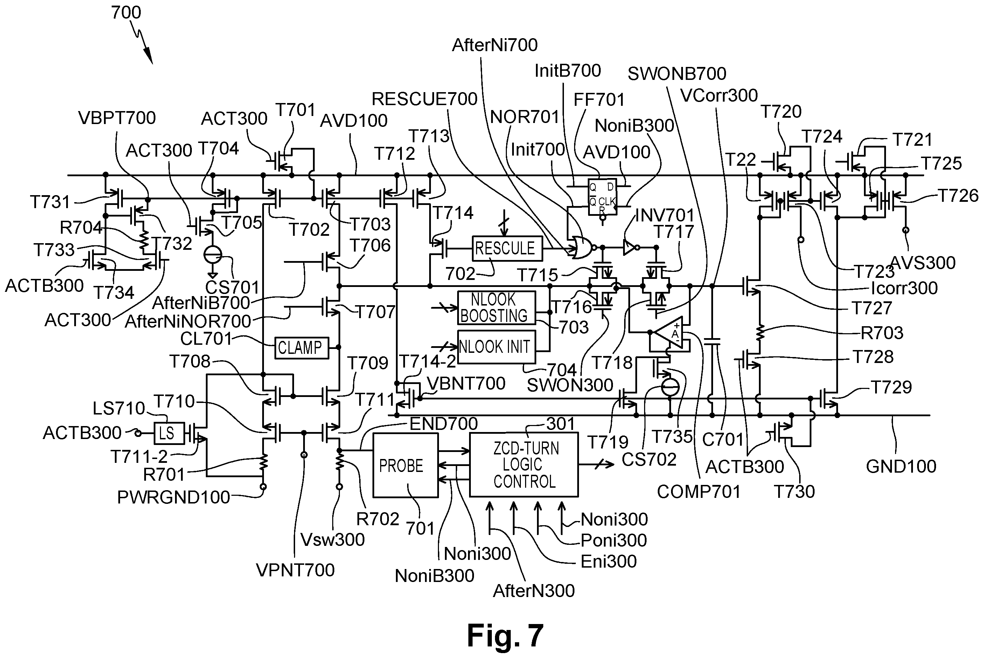

Figure 7 represents, in more detail, an example of a circuit 700 for implementing the circuit 304 of the zero current detection circuit 300 described in relation with Figure 3.

As described previously, circuit 700 receives voltages Poni300, Noni300, AfterN300, and ACT300.

The circuit 700 for example comprises a PMOS transistor T701 receiving on its gate terminal voltage ACT300. A source terminal of transistor T701 is coupled, preferably connected, to a node providing supply voltage AVD100. A drain terminal of transistor T701 is coupled, preferably connected, to a gate terminal of a first differential pair. Transistor T701 is for example controlled by a circuit similar to circuit 301 described in relation with Figure 3, or circuit 400 described in relation with Figure 4. Transistor T701 is used to turn OFF circuit 700 when needed.

The first differential pair comprises, for example, two PMOS transistors T702 and T703. A source terminal of transistor T702 and a source terminal of transistor T703 are coupled, preferably connected, to each other, and to the source terminal of transistor T701 and to the node providing the supply voltage AVD100. A gate terminal of transistor T702 and a gate terminal of transistor T703 are coupled, preferably connected, to each other, and to the drain terminal of transistor T701.

Circuit 700 further comprises, for example, two PMOS transistors T704 and T705 and a current source CS701. The source terminal of transistor T704 is coupled, preferably connected, to the node providing supply voltage AVD100. The drain terminal of transistor T704 is coupled, preferably connected, to the drain terminal of transistor T705. The source terminal of T705 is coupled, preferably connected, to an input of the current source CS701. Gate terminal of transistor T704 is coupled, preferably connected, to the gate terminals of transistors T702 and T703. The gate terminal of transistor T705 receives voltage ACT300.

Circuit 700 further comprises, for example, two PMOS transistors T731 and T732, two NMOS transistors T733 and T734, and a resistor T704. A source terminal of transistor T731 is coupled, preferably connected, to the node receiving voltage AVD100. A drain terminal of transistor T731 is coupled, preferably connected, to a drain terminal of transistor T734 and to a gate terminal of transistor T732. A drain terminal of transistor T731 is coupled, preferably connected, to a source terminal of transistor T732 and to a gate terminal of transistor T704. A drain terminal of transistor T732 is coupled, preferably connected, to a first terminal of resistor R704. A second terminal of resistor R704 is coupled, preferably connected, to the drain terminal of transistor T733. A source terminal of transistor T733 is coupled, preferably connected, to a source terminal of transistor T734. A gate terminal of transistor T733 receives the voltage ACT300. A gate terminal of transistor T734 receives the voltage ACTB300. These four transistors compose a fast kick-on circuit allowing to pull down voltage VBPT700 fast when voltage ACT300 reaches a high level.

Circuit 700 further comprises, for example, a PMOS transistor T706 and a NMOS transistor T707. A source terminal of transistor T706 is coupled, preferably connected, to a drain terminal of transistor T703. A drain terminal of transistor T706 is coupled, preferably connected, to a drain terminal of transistor T707. A gate terminal of transistor T706 receives a voltage AfterNiB700. A gate terminal of transistor T707 receives a voltage AfterNiNor700.

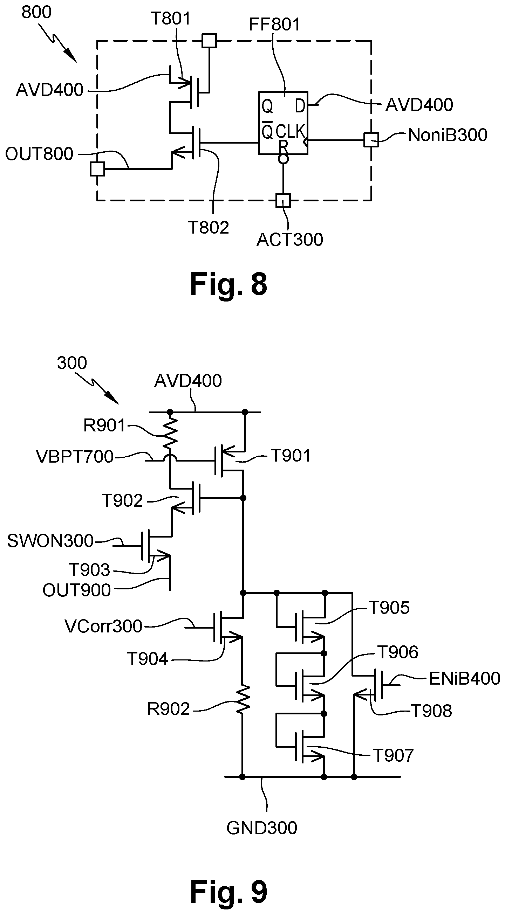

Circuit 700 further comprises, for example, a clamping circuit CL701 (CLAMP) described in more details in relation with Figure 8. An output of clamping circuit CL701 is coupled, preferably connected, to the source terminal of transistor T707.

Circuit 700 further comprises, for example, a current mirror comprising two NMOS transistors T708 and T709. A drain terminal of transistor T708 is coupled, preferably connected, to gate terminals of transistors T708 and T709, and to a drain terminal of transistor T702. A drain terminal of transistor T709 is coupled, preferably connected, to a drain terminal of transistor T707.

Circuit 700 further comprises, for example, a differential pair comprising two NMOS transistors T710 and T711. A source terminal of transistor T710 is coupled, preferably connected, to a source terminal of transistor T708. A source terminal of transistor T711 is coupled, preferably connected, to a source terminal of transistor T709. Gate terminals of transistors T710 and T711 are coupled, preferably connected, to each other and to a node receiving the voltage VPNT700.

Circuit 700 further comprises, for example, two resistors R701 and R702. A first terminal of resistor R701 is coupled, preferably connected, to a drain terminal of transistor T710, and a second terminal of resistor R701 is coupled, preferably connected, to a node receiving the voltage PWRGND100. A first terminal of resistor R702 is coupled, preferably connected, to a drain terminal of transistor T711, and a second terminal of resistor R702 is coupled, preferably connected, to a node receiving the voltage Vsw100.

Circuit 700 further comprises, for example, a level shifter LS701 and a NMOS transistor T711-2. An input of the level shifter LS701 receives voltage ACTB300. An output of level shifter LS701 is coupled, preferably connected, to a gate terminal of transistor T711-2. A drain terminal of transistor T711-2 is coupled, preferably connected, to the drain terminal of the transistor T708. A source terminal of transistor T711-2 is coupled, preferably connected, to the second terminal of the resistor R701 and to the node receiving the reference voltage PWRGND100.

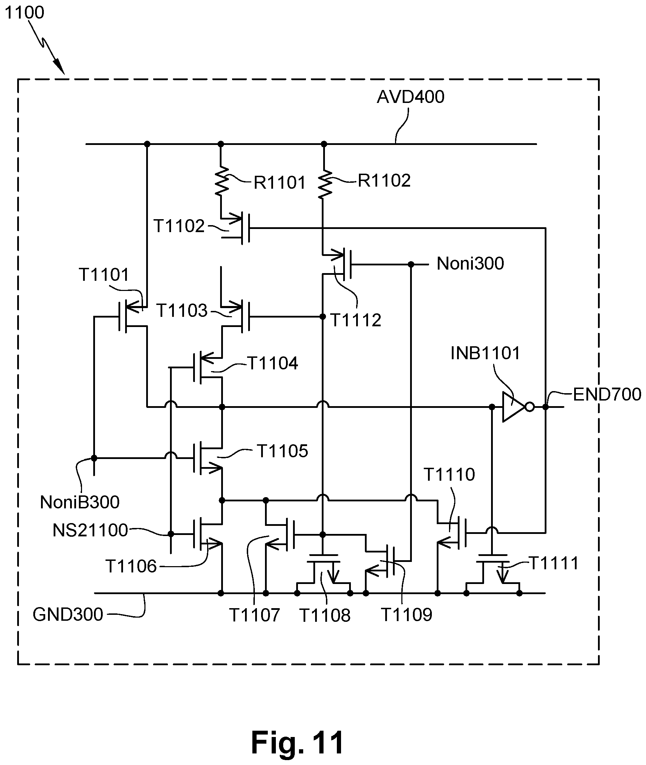

Circuit 700 further comprises, for example, a circuit 701 (PROBE) capable of exchanging voltages with the control circuit 301 of the zero current detection circuit. More particularly, circuit 701 provides a voltage END700 to, and receives the voltages Noni300 and NoniB300 from, the control circuit 301. Moreover, an input of circuit 701 is coupled, preferably connected, to the drain terminal of transistor T711. An example of circuit 701 is described in more detail in relation with Figure 11.

Circuit 700 further comprises, for example, four transistors T712, T713, T714, and T714-2. A source terminal of transistor T712 receives the supply voltage AVD100. A drain terminal of transistor T712 is coupled, preferably connected, to the drain terminal and to the gate terminal of transistor T714-2. The drain terminal of transistor T712 provides a voltage VBNT700. A gate terminal of transistor T712 is coupled, preferably connected, to the gate terminals of transistors T703 and T713. A source terminal of transistor T713 is coupled, preferably connected, to the node providing supply voltage AVD100. A drain terminal of transistor T713 is coupled, preferably connected, to the source terminal of transistor T714. A drain terminal of transistor T714 is coupled, preferably connected, to the drain terminals of transistors T706 and T707. A source terminal of transistor T714-2 receives the reference voltage GND100.

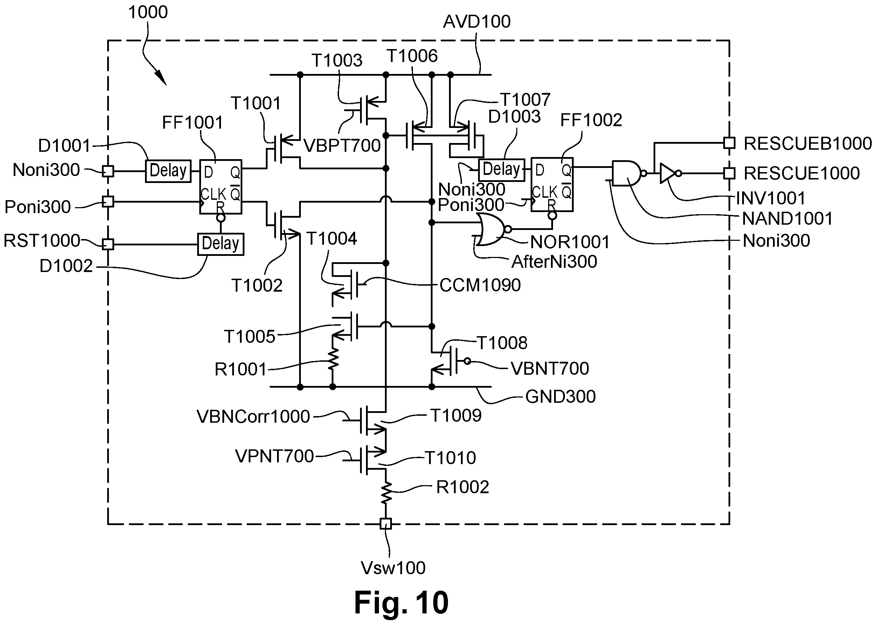

Circuit 700 further comprises, for example, a circuit 702 (RESCUE) described in more detail in relation with Figure 10. An output of circuit 702 is coupled, preferably connected, to the gate terminal of transistor T714. Circuit 702 receives several voltages described in relation with Figure 10.

Circuit 700 further comprises, for example, two initialization circuits 703 (NLOOK BOOSTING) and 704 (NLOOK INIT) described in more detail in relation with Figure 9. An output of circuit 702 is coupled, preferably connected, to the drain terminal of transistor T714. Circuits 703 and 704 receive several voltages described in relation with Figure 10.

Circuit 700 further comprises, for example, three PMOS transistors T715, T717 and T718, an NMOS transistor T716, a NOR gate NOR701, a flip flop FF701, and an inverter INV701.

A first input of the NOR gate NOR701 receives the voltage AfterNi700. A second input of the NOR gate NOR701 is coupled, preferably connected, to an output of circuit 702 providing a voltage RESCUE700. A third input of the NOR gate NOR701 receives the voltage INIT700 from an output *Q̅* of flip flop FF701. An output of the NOR gate NOR701 is coupled, preferably connected, to an input of the inverter INV701, and to a gate terminal of transistor T715. An output of the inverter INV701 is coupled, preferably connected, to a gate terminal of transistor T717.

Concerning flip flop FF701:
- an input D of flip flop FF701 receives voltage AVD100;
- a clock input CLK of flip flop FF701 receives voltage NoniB300;
- an inverted reset input of flip flop FF701 receives voltage EN300; and
- an output Q of flip flop FF701 provides voltage InitB700.

Drain terminals of transistors T715 and T716 are coupled, preferably connected, to the drain terminal of transistor T706, and to a drain terminal of transistor T717 and to a source terminal of transistor T718. Source terminals of transistors T715 and T716 are coupled, preferably connected, to each other. A drain terminal of transistor T717 is coupled, preferably connected, to a drain terminal of transistor T718.

Circuit 700 further comprises, for example, a comparator COMP701, two NMOS transistors T719 and T735, a current source CS702, and a capacitor C701. A first input (+) of the comparator COMP701 is coupled, preferably connected, to the drain terminal of transistor T717 and to the drain terminal of the transistor T718. A second input (-) of the comparator COMP701 is coupled, preferably connected, to an output of the comparator COMP701 and to source terminals of transistors T715 and T716. A supply terminal of comparator COMP701 is coupled, preferably connected, to a drain terminal of transistor T735. A source terminal of transistor T735 is coupled, preferably connected, to an output terminal of current source CS702. The current source CS702 receives the reference voltage GND100. A drain terminal of transistor T719 is coupled, preferably connected, to the supply terminal of comparator COMP701. A source terminal of transistor T719 is coupled, preferably connected, to the node receiving the reference voltage GND300. According to one embodiment, comparator COMP701 is more precise than comparator 500 described in relation with Figure 5.

Circuit 700 further comprises, for example, a capacitor C701 arranged between the drain terminal of transistor T718 and the node receiving the reference voltage GND300. Moreover, capacitor C701 receives voltage VCorr300 which is controlled by voltage AfterN300. Voltage AfterN300 is used by circuit 700 to trigger the charge and the discharge of the capacitor C701, and consequently the charge and discharge of voltage VCorr300. More particularly such a charge is triggered by a high-level of voltage AfterN300.

Circuit 700 further comprises two PMOS transistors T720 and T721. Gate terminals of transistors T720 and T721 receive the voltage ACT300. Source terminals of transistors T720 and T721 receive the supply voltage AVD100.

Circuit 700 further comprises, for example, a current mirror comprising two PMOS transistors T722 and T723. Source terminals of transistors T722 and T723 are coupled, preferably connected, to each other and receive the supply voltage AVD100. Gate terminals of transistors T722 and T723 are coupled, preferably connected, to each other, to the drain terminal of transistor T720, and to the drain terminal of transistor T722. The drain terminal of transistor T723 provides correction current ICorr300.

Circuit 700 further comprises, for example, a PMOS transistor T724. A source terminal of transistor T724 receives supply voltage AVD100. Gate terminal of transistor T724 is coupled, preferably connected, to the gate terminals of transistor T722 and T723.

Circuit 700 further comprises, for example, a current mirror comprising two PMOS transistors T725 and T726. Source terminals of transistors T725 and T726 are coupled, preferably connected, to each other and receive supply voltage AVD100. Gate terminals of transistors T725 and T726 are coupled, preferably connected, to each other, to the drain terminal of transistor T725, to the drain terminal of transistor T721, and to the drain terminal of transistor T724. Drain terminal of transistors T726 provides correction current ICorrAVS300.

Circuit 700 further comprises, for example, two NMOS transistors T727 and T728, and a resistor R703. A drain terminal of transistor T727 is coupled, preferably connected, to the drain terminal of transistor T722. A source terminal of transistor T727 is coupled, preferably connected, to a first terminal of resistor R703. A second terminal of resistor R703 is coupled, preferably connected, to a drain terminal of transistor T728. A source terminal of transistor T728 is coupled, preferably connected, to the node providing the reference voltage GND300. A gate terminal of transistor T727 is coupled, preferably connected, to the source terminal of transistor T728. A gate terminal of transistor T728 receives the voltage ACTB300.

Circuit 700 further comprises, for example, two NMOS transistors T729 and T730. A drain terminal of transistor T729 is coupled, preferably connected, to the drain terminals of transistors T724 and T725. A source terminal of transistor T729 is coupled, preferably connected, to the node providing reference voltage GND300. A gate terminal of transistor T729 is coupled, preferably connected, to gate terminals of transistors T714-2 and T719. A drain terminal of transistor T730 is coupled, preferably connected, to the gate terminal of transistor T729. A source terminal of transistor T730 is coupled, preferably connected, to the node providing reference voltage GND300. A gate terminal of transistor T730 receives the voltage ACT300.

Circuit 700 operates as follow. When voltage ACT300 reaches a high level, corresponding to a logic 1, the zero current detection circuit starts working. During the period wherein voltage AfterN300 is at logic 1, the comparator COMP701 of circuit 700 compares voltages PWRGND100 and Vsw100. Sampling transistors T715 to T718 are turned ON, and the voltage on the sample and hold capacitor C701 is changed. The correction voltage Vcorr300 changes currents Icorr and IcorrAVS which are applied to the main comparator of circuit 500.

When voltage ACT300 reaches a low level, corresponding to a logic 0, the current comparator other sub-circuits of the zero current detection circuit are turned OFF to save the power, and sampling transistors T715 to T718 are also turned OFF. However, the voltage on capacitor C701 is maintained, even after a long time by using the buffer COMP701 which clamps the voltage between source and drains of transistors T717 and T718 to reduce the leakage.

Figure 8 represents, in more detail, an example of a clamping circuit 800 for implementing the circuit 701 of circuit 700 described in relation with Figure 7.

Circuit 800 comprises, for example, a flip flop FF801. Flip flop FF801 is a D type flip flop, comprising three inputs R, CLK and D, and two outputs Q and ***Q̅*.** Input D receives the supply voltage AVD100. Input R receives the voltage ACT300. Input CLK receives the voltage NoniB300.

Circuit 800 further comprises, for example, a PMOS transistor T801 and NMOS transistor T802. A source terminal of transistor T801 receives the supply voltage AVD100. A drain terminal of transistor T801 is coupled, preferably connected, to a drain terminal of transistor T802. A source terminal of transistor T802 provides a voltage to an output node OUT800 of circuit 800.

According to an example, this output node OUT800 is coupled, preferably connected, to the source terminal of transistor T707 of the circuit 700. Circuit 800 is used to prevent a fast discharge that may occurs in the source terminal of transistor T707 of the circuit 700.

Figure 9 represents, in more detail, an example of a boost circuit 900 for implementing the circuit 703 of circuit 700 described in relation with Figure 7.

Circuit 900 comprises, for example, a resistor R901, a PMOS transistor T901 and two NMOS transistors T902 and T903. A first terminal of resistor R901 is coupled, preferably connected, to a node providing the supply voltage AVD100. A second terminal of resistor R901 is coupled, preferably connected, to a drain terminal of transistor T902. A source terminal of transistor T901 is coupled, preferably connected, to the node providing the supply voltage AVD100. A drain terminal of transistor T901 is coupled, preferably connected, to a gate terminal of transistor T902. A gate terminal of transistor T901 receives the voltage VBPT300. A source terminal of transistor T902 is coupled, preferably connected, to a drain terminal of transistor T903. A source terminal of transistor T903 is coupled, preferably connected, to an output node OUT900 of circuit 900.

Circuit 900 further comprises, for example, a NMOS transistor T904 and a resistor R902. A drain terminal of transistor T904 is coupled, preferably connected, to the gate terminal of transistor T902 and to the drain terminal of transistor T901. A source terminal of transistor T904 is coupled, preferably connected, to a first terminal of resistor R902. A second terminal of resistor R902 is coupled, preferably connected, to a node receiving the reference voltage GND300.

Circuit 900 further comprises, for example, three NMOS transistors T905, T906 and T907. A drain terminal of transistor T905 is coupled, preferably connected, to its gate terminal and to the drain terminal of transistor T904. A drain terminal of transistor T906 is coupled, preferably connected, to its gate terminal and to the source terminal of transistor T907. A drain terminal of transistor T907 is coupled, preferably connected, to its gate terminal and to the node receiving the reference voltage GND300.

The circuit 900 further comprises, for example, a NMOS transistor T908. A drain terminal of transistor T908 is coupled, preferably connected, to the drain terminal of transistor T904. A source terminal of transistor T908 is coupled, preferably connected, to the node receiving the reference voltage GND300. A gate terminal of transistor T908 receives voltage ENiB400.

According to an example, this output node OUT900 is coupled, preferably connected, to the source terminal of transistor T707 of the circuit 700. Circuit 900 is used to boost the voltage at the source terminal of transistor T707 of circuit 700.

With some little amendments, circuit 900 can also provide an example implementation of the circuit 704 of circuit 700. In that case, circuit 900 is used to help the initialization of the voltage at the source terminal of transistor T707 of the circuit 700. More particularly, to be an example of circuit 704, voltage SWON300 is for example replaced by the voltage INIT300, and voltage ENiB400 is replaced by the voltage INITB300.

Figure 10 represents, in more detail, an example of a clamping circuit 1000 for implementing the circuit 702 of circuit 700 described in relation with Figure 7.

Circuit 1000 comprises, for example, a flip flop FF1001 and two delay elements D1001 and D1002. Flip flop FF1001 is a D type flip flop, comprising three inputs R, CLK and D, and two outputs Q and ***Q̅*.** Input D of flip flop FF1001 is coupled, preferably connected, to an output of delay element D1001. An input of delay element D1001 receives the voltage Noni300. Input CLK of flip flop FF1001 receives the voltage Poni300. Input R of flip flop FF1001 is coupled, preferably connected, to an output of delay element D1002. An input of delay element D1002 receives a reset voltage RST1000.

Circuit 1000 further comprises, for example, a PMOS transistor T1001 and an NMOS transistor T1002. A source terminal of transistor T1001 is coupled, preferably connected, to a node providing the supply voltage AVD100. A gate terminal of transistor T1001 is coupled, preferably connected, to the output Q of flip flop FF1001. A source terminal of transistor T1002 is coupled, preferably connected, to a node providing the voltage GND300. A gate terminal of transistor T1002 is coupled, preferably connected, to the output ***Q̅*** of flip flop FF1002.

Circuit 1000 further comprises, for example, an NMOS transistor T1003, two PMOS transistors T1004 and T1005, and a resistor R1001. A source terminal of transistor T1003 receives the supply voltage AVD100. A drain terminal of transistor T1003 is coupled, preferably connected, to the drain terminal of transistor T1001, and to the drain terminal of transistor T1004. A gate terminal of transistor T1003 receives the voltage VBPT700. A source terminal of transistor T1004 is coupled, preferably connected, to a drain terminal of transistor T1005. A gate terminal of transistor T1004 receives a voltage CCM1000. A source terminal of transistor T1005 is coupled, preferably connected, to a first terminal of resistor R1001. A second terminal of resistor R1001 is coupled, preferably connected, to a node providing the reference voltage GND300.

Circuit 1000 further comprises, for example, two PMOS transistors T1006 and T1007. Source terminals of transistors T1006 and T1007 are coupled, preferably connected, to the node providing supply voltage AVD100. Gate terminals of transistors T1006 and T1007 are coupled, preferably connected, to each other, to the drain terminal of transistor T1007, and to the drain terminal of transistor T1003. A drain terminal of transistor T1006 is coupled, preferably connected, to the drain terminal of transistor T1002 and to the gate terminal of transistor T1002.

Circuit 1000 further comprises, for example, an NMOS transistor T1008. A source terminal of transistor T1008 is coupled, preferably connected, to the node receiving the reference voltage GND300. A drain terminal of transistor T1008 is coupled, preferably connected, to the gate terminal of transistor T1005 and to the drain terminal of transistor T1003. A gate terminal of transistor T1008 receives a voltage VBNT700.

Circuit 1000 further comprises, for example, two NMOS transistors T1009 and T1010 and a resistor R1002. A drain terminal of transistor T1009 is coupled, preferably connected, to the drain terminal of transistor T1003. A source terminal of transistor T1009 is coupled, preferably connected, to the source terminal of transistor T1010. A drain terminal of transistor T1010 is coupled, preferably connected, to a first terminal of resistor R1002. A gate terminal of transistor T1010 receives a voltage VPNT700. A second terminal of resistor R1002 receives the voltage Vsw100.

Circuit 1000 further comprises a flip flop FF1002 and a delay element D1003, a NOR gate NOR1001, a NAND gate NAND1001 and an inverter INV1001. Flip flop FF1002 is a D type flip flop, comprising three inputs R, CLK and D, and two outputs Q and **Q̅.** Input D of flip flop FF1002 is coupled, preferably connected, to an output of delay element D1003. An input of delay element D1003 receives the voltage Noni300. Input CLK of flip flop FF1002 receives the voltage Poni300. Input R of flip flop FF1002 is coupled, preferably connected, to an output of the NOR gate NOR1001. A first input of NOR gate NOR1001 is coupled, preferably connected, to the drain terminal of transistor T1003. A second input of NOR gate NOR1001 receives the voltage AfterNi700. Output Q of flip flop FF1002 is coupled, preferably connected, to a first input of NAND gate NAND1001. A second input of NAND gate NAND1001 receives the voltage Noni300. An output of NAND gate NAND1001 is coupled, preferably connected, to an input of inverter INV1001, and provides a voltage RESCUEB1000. An output of inverter INV1001 provides a voltage RESCUE1000.

According to an example, the voltage RESCUEB1000 is used to control transistor T714 of circuit 700, and the voltage RESCUE1000 is provided to an input of NOR gate NOR701. Circuit 1000 is used to boost the voltage at the source terminal of transistor T707 of circuit 700.

According to an example, and with respect to Figure 1, circuit 1000 may be used to keep the offset of comparator 101-Comp at a same level when the current in diode L101 is not equal to zero.

Figure 11 represents, in more detail, an example of a clamping circuit 1100 for implementing the circuit 701 of circuit 700 described in relation with Figure 7.

Circuit 1100 comprises, for example, a PMOS transistor T1101. A source terminal of transistor T1101 is coupled, preferably connected, to a node providing the supply voltage AVD100. A gate terminal of transistor T1101 receives the voltage NoniB300.

Circuit 1100 further comprises, for example, two resistors R1101 and R1102. A first terminal of resistor R1101 is coupled, preferably connected, to a first terminal of resistor R1101 and to the node providing the supply voltage AVD100.

Circuit 1100 further comprises, for example, three PMOS transistors T1102, T1103 and T1104, and two NMOS transistors T1105 and T1106. A source terminal of transistor T1102 is coupled, preferably connected, to a second terminal of resistor R1101. A drain terminal of transistor T1102 is coupled, preferably connected, to a source terminal of transistor T1103. A drain terminal of transistor T1103 is coupled, preferably connected, to a source terminal of transistor T1104. A drain terminal of transistor T1104 is coupled, preferably connected, to a drain terminal of transistor T1105. A source terminal of transistor T1105 is coupled, preferably connected, to a drain terminal of transistor T1106. A source terminal of transistor T1105 is coupled, preferably connected, to a node providing the reference voltage GND300. Gate terminals of transistors T1104 and T1106 receive a voltage Ns21100. A gate terminal of transistor T1105 receives the voltage NoniB300.

Circuit 1100 further comprises, for example, five PMOS transistors T1107, T1108, T1109, T1110, and T1111. A drain terminal of transistor T1107 is coupled, preferably connected, to the drain terminal of transistor T1106. A source terminal of transistor T1107 is coupled, preferably connected, to the node providing the reference voltage GND300. Gate terminals of transistors T1107 and T1108 are coupled, preferably connected, to each other and to the gate terminal of transistor T1103. Both conductive terminals of transistor T1108 are coupled, preferably connected, to each other, and to the node providing the reference voltage GND300. A drain terminal of transistor T1109 is coupled, preferably connected, to the gate terminals of transistors T1108 and T1109. A source terminal of transistor T1108 receives the reference voltage GND300. A drain terminal of transistor T1110 is coupled, preferably connected, to the drain terminals of transistors T1106 and T1107. A source terminal of transistor T1110 receives the reference voltage GND300. Both conductive terminals of transistor T1111 are coupled, preferably connected, to each other, and to the node providing the reference voltage GND300.

Circuit 1100 further comprises, for example, a PMOS transistor T1112. A source terminal of transistor T1112 is coupled, preferably connected, to a second terminal of resistor R1102. A drain terminal of transistor T1112 is coupled, preferably connected, to the gate terminal of transistor T1103 and to the gate terminals of transistors T1107 and T1108. A gate terminal of transistor T1112 is coupled, preferably connected, to the gate terminal of transistor T1109, and receives the voltage Noni300.

Circuit 1100 further comprises, for example, an inverter INV1101. An input of inverter INV1101 is coupled, preferably connected, to drain terminals of transistors T1101, T1104 and T1105, and to the gate terminal of transistor T1111. An output of inverter INV1101 provides the voltage END700 to the gate terminals of transistors T1102 and T1110. This output of inverter INV1101 also forms the output node of circuit 1100.

According to an example, circuit 1100 is used to enable and disable a tuning operation of the offset voltage of the comparator.

Figure 12 represents, in more detail, an example of a logic circuit 1200 for implementing the logic circuit 301 of circuit 300 described in relation with Figure 3.

Logic circuit 1200 comprises two inverters INV1201 and INV1202 mounted in series. An input of inverter INV1201 receives voltage Pon300, and an output of inverter INV1201 provides voltage PoniB300. An input of inverter INV1202 receives voltage PoniB300, and an output of inverter INV1202 provides voltage Poni300.

Logic circuit 1200 further comprises two inverters INV1203 and INV1204 mounted in series. An input of inverter INV1203 receives voltage Non300, and an output of inverter INV1203 provides voltage NoniB300. An input of inverter INV1204 receives voltage NoniB300, and an output of inverter INV1204 provides voltage Noni300.

Logic circuit 1200 further comprises two inverters INV1205 and INV1206 mounted in series. An input of inverter INV1205 receives voltage EN300, and an output of inverter INV1205 provides voltage ENiB300. An input of inverter INV1206 receives voltage ENiB300, and an output of inverter INV1206 provides voltage ENi300.

Logic circuit 1200 further comprises two inverters INV1207 and INV1208 mounted in series. An input of inverter INV1207 receives voltage ACT300, and an output of inverter INV1207 provides voltage ACTiB300. An input of inverter INV1208 receives voltage ACTiB300, and an output of inverter INV1208 provides voltage ACTi300.

Logic circuit 1200 further comprises two NAND logic gates Nand1201 and Nand1202. Gate Nand1201 provides voltage AfterNiB300, and receives:
- voltage AfterN300;
- voltage ENi300; and
- an output of gate Nand1202.

Gate Nand1202 receives voltages END700 and Poni300.

Logic circuit 1200 further comprises an inverter INV1209, a flip flop FF1201, a NOR logic gate NOR1201, and a NOR logic gate NOR1202. An input of inverter INV1209 receives voltages AfterNiB300, and an output of inverter INV1209 is coupled, preferably connected, to a clock input CLK of flip flop FF1201. An input D of flip flop FF1201 receives voltage AVD100. A reset input of flip flop FF1201 is coupled, preferably connected, to an output of NOR logic gate NOR1201. An output Q of flip flop FF1201 provides AfterNiN1200. An output ***Q̅*** of flip flop FF1201 provides AfterNiNB1200. NOR gate NOR1201 receives voltages ENi300 and END700. NOR gate NOR 1202 receives voltages AfterNiB300 and AfterNiNB1200, and provides voltages AfterNNOR1200.

Various embodiments and variants have been described. Those skilled in the art will understand that certain features of these embodiments can be combined and other variants will readily occur to those skilled in the art.

Finally, the practical implementation of the embodiments and variants described herein is within the capabilities of those skilled in the art based on the functional description provided hereinabove.

## Claims

1. A zero current detection (101; 300) circuit comprising:
- a first comparator (101-Comp; 302; 500) configured to compare a first voltage (Vsw100), representative of a first current (IL101), with a first threshold voltage (Vos101);
- a calibration circuit (101-CAL; 303, 304; 700) configured to modify the value of the first threshold voltage (Vos101) in view of process, voltage, and/or temperature variations.

2. Circuit according to claim 1, wherein said first threshold voltage (Vos101) is an offset voltage of said first comparator (101-Comp; 302; 500).

3. Circuit according to claim 1 or 2, wherein said calibration circuit (700) comprises a second comparator circuit (COMP701).

4. Circuit according to claim 3, wherein said second comparator circuit (COMP701) is more precise than the first comparator (101-Comp; 302; 500).

5. Circuit according to any of claims 1 to 4, comprising a logic circuit (301; 400) configured to be the main control circuit of the zero current detection circuit (101; 300).

6. DC-DC converter comprising a zero current detection circuit according to any of claims 1 to 5.

7. Converter according to claim 6, comprising two switches (S101, S102) coupled in series, and a coil (L101) having one of its terminals coupled to the middle node between said two switches (S101, S102).

8. Converter according to claim 7, wherein said zero current detection circuit is configured to detect when the current in said coil is equal to zero.
